# EUROPÄISCHE PATENTSCHRIFT

(11) **EP 2 607 515 B1**
(45) Veröffentlichungstag und Bekanntmachung des Hinweises auf die Patenterteilung: **17.06.2020**
(21) Anmeldenummer: 12196853.1
(22) Anmeldetag: 13.12.2012
(51) Int. Cl.: C23C 10/00, C23C 10/10, C23C 10/20, C23C 10/32, C23C 10/38, C23C 10/42, C23C 28/02, C23C 30/00, C23C 16/10, B32B 15/01

(54) **Diffusionsbeschichtungsverfahren und damit hergestellte Chromschicht**
Diffusion coating method and chromium layer produced according to the method
Procédé de revêtement par diffusion et couche de chrome ainsi fabriquée

(30) Priorität: 20.12.2011 DE 102011089131
(43) Veröffentlichungstag der Anmeldung: 26.06.2013
(73) Patentinhaber: MTU Aero Engines AG, 80995 München (DE)
(72) Erfinder: Pillhöfer, Horst, 85422 Röhrmoos (DE); Seuss, Siegfried, 80939 München (DE); Niedermeier, Markus, 80805 München (DE); Müller, Stefan, 80634 München (DE)

(56) Entgegenhaltungen:
- CA-A- 970 259
- DE-A1-102008 039 969
- DE-A1-102008 053 540
- FR-A1- 2 429 271
- GB-A- 954 931
- US-A1- 2011 058 952

## Beschreibung

### HINTERGRUND DER ERFINDUNG

### GEBIET DER ERFINDUNG

Die vorliegende Erfindung betrifft ein Verfahren zur Herstellung einer Beschichtung aus einem Metall oder einer Metalllegierung auf einem Substrat über einen Diffusionsprozess, bei dem das Substrat in einer Atmosphäre einer Temperaturbehandlung ausgesetzt wird, wobei die Atmosphäre mindestens ein Metallhalogenid des abzuscheidenden Metalls oder der Metalllegierung umfasst. Darüber hinaus betrifft die vorliegende Erfindung eine Chromschicht, die insbesondere nach dem erfindungsgemäßen Verfahren hergestellt ist und eine Diffusionszone in das Substrat sowie eine Aufbauzone auf dem Substrat aufweist.

### STAND DER TECHNIK

Aus dem Stand der Technik sind die Diffusionsschichten zur Chrom- und Zinkanreicherung von Stahl, wie beispielsweise Inchromieren, oder das Aufbringung von Aluminium- und Chrom-Aluminium-reichen Diffusionsbeschichtungen (Alitieren, Chromalitieren etc.) bekannt. Diese Diffusionsschichten haben jedoch den Nachteil, dass sie zur Sprödigkeit neigen und es zu thermischen Ermüdungsanrissen kommt. Darüber hinaus besteht eine Problematik auch darin, dass das aufzubringende Metall, wie z.B. Chrom, in zu geringer Konzentration in das Substrat eindiffundiert, so dass es beispielsweise seine korrosionsschützenden Eigenschaften nicht in ausreichender Weise aufweist. Ferner besteht ein weiteres Problem darin, dass bei der Herstellung von Diffusionsschichten, bei der das Substrat in einem Pulverbett angeordnet ist, durch überschüssiges Pulver eine hohe Menge an Abfall anfällt.

Beispiele für Verfahren zur Herstellung von Chromdiffusionsschichten sind in der US 3,312,546, DE 10 2008 039 969 A1, DE 10 2008 053 540 A1, US 2011/0058952 A1, FR 2 429 271 A1, GB 954 931 A, CA 970 259 A und der US 3,623,901 offenbart. Bei den dort veröffentlichten Verfahren werden unter anderem die zu beschichtenden Substrate mit einem chromhaltigen Pulver beschichtet, wobei während des Auslagerungsprozesses in die Atmosphäre ein halogenhaltige Gas zugegeben wird. Damit soll einerseits eine mehrseitige Beschichtung von Stahl mit einer glänzenden Oberfläche sowie andererseits eine festhaftende, schützende Chromschicht auf Stahlprodukten erzeugt werden.

### OFFENBARUNG DER ERFINDUNG

### AUFGABE DER ERFINDUNG

Obwohl im Stand der Technik bereits verschiedene Verfahren für die Herstellung von Diffusionsschichten und insbesondere Chromdiffusionsschichten bekannt sind, besteht weiterhin Bedarf, eine Optimierung dahingehend zu erzielen, dass einerseits eine starke Anreicherung des abzuscheidenden Metalls oder der Metalllegierung im Bereich der Diffusionsbeschichtung erzielt wird und dass andererseits eine derartige Schicht eine ausreichende Duktilität aufweist, um den Einsatzanforderungen zu genügen. Darüber hinaus soll das Verfahren umweltfreundlich sein.

Diese Aufgabe wird gelöst durch ein Verfahren mit den Merkmalen des Anspruchs 1 sowie eine Chrombeschichtung mit den Merkmalen des Anspruchs 12. Vorteilhafte Ausgestaltungen sind Gegenstand der abhängigen Ansprüche.

Das erfindungsgemäße Verfahren zeichnet sich dadurch aus, dass entgegen dem Stand der Technik, bei welchem ein Metallhalogenid zur Erzeugung von Diffusionsschichten entweder in einem pulverförmigen Einsatzmittel oder in einer Gasatmosphäre vorgesehen ist, eine Kombination von gasförmigen Metallhalogeniden und festen und/oder flüssigen Metallhalogeniden eingesetzt wird.

Entsprechend wird bei dem erfindungsgemäßen Verfahren der Diffusionsprozess zur Beschichtung eines Substrats mit einem Metall oder einer Metalllegierung in einer Atmosphäre durchgeführt, die mindestens ein Metallhalogenid des abzuscheidenden Metalls oder der Metalllegierung umfasst, wobei jedoch zusätzlich das Substrat zumindest teilweise mit einer Lage versehen wird, welche ein Metallhalogenid in fester und/oder flüssiger Form mit ebenfalls mindestens einem Metallhalogenid des abzuscheidenden Metalls oder der Metalllegierung, vorzugsweise ein Metallhalogenid mit denselben Bestandteilen wie das Metallhalogenid der umgebenden Atmosphäre umfasst. Die verwendeten Metallhalogenide können sich beispielsweise durch unterschiedliche Oxidationsstufen unterscheiden, um gleichzeitig gasförmige und feste oder flüssige Metallhalo - genide mit denselben Bestandteilen bereit zu stellen. Darüber hinaus können auch mehrere Metallhalogenide, wie beispielsweise Aluminium- und Chrom-Halogenide eingesetzt werden, um eine AlCr-Legierung abzuscheiden.

Mit dem erfindungsgemäßen Verfahren kann der Anteil des abzuscheidenden Metalls in der Diffusionszone der erzeugten Diffusionsschicht, also in dem Bereich der erzeugten Schicht, der sich in das Substrat hinein erstreckt, erhöht werden, so dass sich ein hoher Anteil des abzuscheidenden Metalls in der Diffusionszone ergibt. Entsprechend kann durch die effektive Einlagerung des abzuscheidenden Metalls auch die Menge des für den Diffusionsprozess zur Verfügung zu stellenden Materials und somit die im Prozess anfallende Abfallmenge reduziert werden. Darüber hinaus weist die Aufbauzone der Diffusionsschicht, die sich oberhalb der ursprünglichen Oberfläche des Substrats abscheidet, einen hohen Porenanteil auf, so dass die Schicht insgesamt eine gute Duktilität aufweist.

Das Metallhalogenid kann in flüssiger oder fester Form auf dem Substrat angeordnet werden. Ein flüssiges Metallhalogenid kann durch Streichen, Tauchen, Besprühen und dergleichen in Form eines Films auf dem Substrat abgeschieden werden.

Ein festes Metallhalogenid kann in Pulverform auf dem Substrat aufgebracht werden, wobei das Pulver Metallhalogenidpulverpartikel mit mittleren oder maximalen Partikelgrößen im Bereich von 2 µm bis 100 µm, insbesondere 5 µm bis 50 µm aufweisen kann. Das feste Metallhalogenid in Pulverform kann unmittelbar auf der Oberfläche des Substrats oder auf einem Film mit flüssigem Metallhalogenid abgeschieden werden.

Das pulverförmige Metallhalogenid kann zusammen mit weiteren Metallpartikeln des abzuscheidenden Metalls oder der Metalllegierung und/oder mit Inertpartikeln, sogenanntem neutralen Füllmaterial, wie beispielsweise Aluminiumoxid oder dergleichen, auf dem Substrat aufgebracht werden.

Die Metallpartikel oder Inertpartikel, die zusammen mit den Metallhalogenidpartikeln auf dem Substrat aufgebracht werden, können eine durchschnittliche oder maximale Korngröße im Bereich von 5 µm bis 4 mm, insbesondere 10 µm bis 400 µm aufweisen.

Bei Aufbringung von Metallhalogenidpartikeln und Metallpartikeln können diese im Verhältnis eins zu eins gemischt sein oder der Metallhalogenidpartikelanteil in der Pulvermischung kann im Bereich von 0,2 bis 50 Vol.%, vorzugsweise 0,2 bis 10 Vol.%, gewählt werden.

Die Lage aus flüssigem Metallhalogenid und/oder pulverförmigem Metallhalogenid wird so ausgebildet, dass die Komponenten der aufgebrachten Lage unter den Bedingungen der Temperaturbehandlung bei Nichtberücksichtigung der ablaufenden Reaktionen ihre Aggregatszustände im Wesentlichen beibehalten.

Die metallhalogenidhaltige Atmosphäre umfasst neben dem Metallhalogenid ein Inertgas, wobei das Inertgas beispielsweise Argon sein kann. Das Inertgas kann einen Partialdruck von 20 mbar bis 1050 mbar aufweisen, während das Metallhalogenid einen Partialdruck von 5 mbar bis 800 mbar aufweisen kann. Die Atmosphäre kann so hergestellt werden, dass entsprechende Halogenide mittels geeigneter Verdampfer verdampft werden oder Mischungen von Metallen und Halogeniden höherer Oxidationsstufen erzeugt werden, die bei hohen Temperaturen gasförmige Metallhalogenide erzeugen, wobei der entsprechende Metallhalogeniddampf in die Atmosphäre um das Substrat eingeführt wird.

Die Temperaturbehandlung des Substrats kann bei einer Temperatur im Bereich von 800 °C bis 1200 °C, insbesondere 900 °C bis 1150 °C, und für eine Dauer von 0,5 bis 24 Stunden durchgeführt werden.

Die Lage mit flüssigem und/oder festem Metallhalogenid kann mit einer Dicke von 0,05 bis 20 mm, insbesondere 0,2 bis 10 mm, auf dem Substrat aufgebracht werden, wobei auch nur eine lokal begrenzte Aufbringung auf dem Substrat möglich ist, und zwar in den Bereichen, in denen eine besonders starke Abscheidung des entsprechenden Metalls oder der Metalllegierung gewünscht ist.

Als Metalle, die abgeschieden werden, kommen Chrom, Aluminium, Hafnium, Zirkon und/oder Yttrium in Betracht.

Eine entsprechende Diffusionsschicht, die mit dem erfindungsgemäßen Verfahren hergestellt worden ist, zeichnet sich dadurch aus, dass in der Diffusionszone der Anteil des abgeschiedenen Metalls ≥ 30 Gew. % ist, insbesondere ≥ 50 Gew. % oder bis zu 80 Gew.%. Außerdem weist die Aufbauschicht der entsprechenden Diffusionsschicht einen hohen Porenanteil im Bereich von 0,2 bis 40 Vol.% auf, so dass eine gute Duktilität der Diffusionsschicht gegeben ist.

Insbesondere kann mit dem erfindungsgemäßen Verfahren eine Chromschicht auf einem Nickel-Basis-Werkstoff, insbesondere einer Nickel-Basis-Legierung für den Flugtriebwerkbau abgeschieden werden, wobei in der Diffusionszone der Anteil des α-Chroms ≥ 50 % des gesamten Chromgehalts ist.

### KURZBESCHREIBUNG DER FIGUREN

Die beigefügten Zeichnungen zeigen in rein schematischer Weise in
- Fig. 1: eine Schnittansicht durch den Randbereich eines zu beschichtenden Substrats mit der angrenzenden Atmosphäre während der Beschichtung; und in
- Fig. 2: eine teilweise Querschnittansicht des Randbereichs des Substrats nach erfolgter Beschichtung.

### AUSFÜHRUNGSBEISPIEL

Weitere Vorteile, Kennzeichen und Merkmale der vorliegenden Erfindung werden bei der nachfolgenden detaillierten Beschreibung eines Ausführungsbeispiels deutlich, wobei die Erfindung nicht auf dieses Ausführungsbeispiel beschränkt ist.

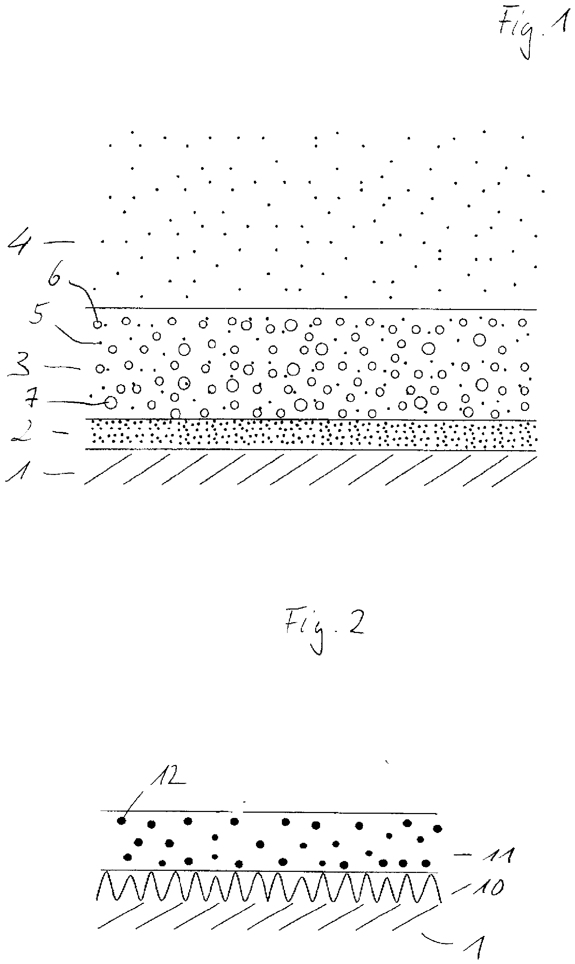

Die Fig. 1 zeigt den Querschnitt durch den Randbereich eines zu beschichtenden Substrats sowie die angrenzenden Umgebung während der Beschichtung.

Das Substrat 1 ist mit einem Film 2 versehen, der ein Metallhalogenid umfasst, und zwar im vorliegenden Ausführungsbeispiel CrCl₂. Das CrCl₂ weist als Metallbestandteil Chrom auf, da als Beschichtung auf dem Substrat 1 eine Chromschicht ausgebildet werden soll. Das Substrat 1 kann beispielsweise durch eine Nickelbasislegierung, wie sie im Triebwerksbau eingesetzt wird, gebildet sein.

Oberhalb des Films 2 mit dem CrCl₂ ist eine Pulverschicht vorgesehen, welche ebenfalls ein Metallhalogenid umfasst, wobei im vorliegenden Fall die Metallkomponente des Halogenids wiederum Chrom ist. Allerdings handelt es sich hier um ein pulverförmiges Chromhalogenid einer höheren Oxidationsstufe, nämlich beispielsweise CrCl₃. Die CrCl₃ weisen eine Korngröße von kleiner oder gleich 5 µm auf. Zusätzlich zu den CrCl₃-Partikeln sind in der Pulverschicht 3 Metallpartikel 6 vorgesehen, und zwar im vorliegenden Fall wiederum Chrompartikel. Die Chrompartikel haben eine Korngröße von ca. 40 µm. Der Anteil der Chrompartikel zu den CrCl₃-Partikeln kann so gewählt sein, dass das Verhältnis zwischen Chrompartikeln 6 und CrCl₃-Partikeln 5 eins zu eins bezogen auf das Volumen ist. Allerdings sind auch Anteile von 0,2 bis 50 Vol.%, vorzugsweise 0,2 bis 10 Vol.% CrCl₃ möglich.

Die Pulverschicht 2 und/oder 3 kann zusätzlich ein Bindemittel aufweisen.

Darüber hinaus kann man in der Pulverschicht 3 größere Metallpartikel oder Inertpartikel 7 mit einer durchschnittlichen oder maximalen Korngrößen im Bereich von 5 µm bis 4 mm vorsehen, die eine offenzellige Struktur der Pulverschicht gewährleisten und einen ausreichenden Gasaustausch ermöglichen.

Die umgebende Atmosphäre 4 wird so gewählt, dass die Atmosphäre 4 ebenfalls ein Metallhalogenid des abzuscheidenden Metalls, also im vorliegenden Fall ein Chromhalogenid, umfasst. Im vorliegenden Fall der Chromabscheidung auf einem Nickel-Basis-Werkstoff kann das Metallhalogenid als ClCr oder ClCr₂ vorliegen.

Neben dem Metallhalogenid umfasst die Atmosphäre 4 ein Inertgas, wie beispielsweise Argon.

Die Partialdrücke des Inertgases und des Metallhalogenids können so gewählt werden, dass das Inertgas mit einem Druck im Bereich von 20 mbar bis 1200 mbar vorliegt, während das Metallhalogenid mit einem Partialdruck im Bereich von 5 mbar bis 800 mbar vorliegt.

Die Beschichtung erfolgt bei Temperaturen zwischen 800 °C und 1200 °C, beispielsweise 1130 °C mit einer Auslagerungszeit von 0,5 Stunden bis 24 Stunden.

Da eine Chromierung des Substrats 1 auch alleine über die entsprechende Gasphase erfolgen kann, kann die Lage aus Film 2 und Pulverschicht 3 lediglich lokal begrenzt in Bereichen des Substrats 1 vorgesehen werden, die einer besonders hohen Chromierung bedürfen. Allerdings ist es natürlich auch möglich, die Lage aus flüssigem Film 2 und pulverförmiger Schicht 3 ganzflächig auf dem Substrat 1 vorzusehen.

Die Gesamtdicke der Lage aus Film 2 und Pulverschicht 3 kann im Bereich von 0,1 mm bis 20 mm gewählt werden.

Darüber hinaus ist es auch möglich, entweder nur die pulverförmige Schicht 3 oder nur den Film mit dem flüssigen Metallhalogenid vorzusehen.

Darüber hinaus kann in der pulverförmigen Schicht 3 auf den Zusatz von grobkörnigen Inertpartikeln oder entsprechenden Metallpartikeln verzichtet werden.

Bei der Durchführung einer entsprechenden Chromierung ergibt sich eine Chromschicht auf dem Substrat, nämlich beispielsweise dem Nickel-Basis-Werkstoff, wie sie in Fig. 2 dargestellt ist. Auf dem Substrat 1 bildet sich eine Diffusionszone 10 aus, die von der ursprünglichen Substratoberfläche nach innen in das Substrat gerichtet ist. Zusätzlich ist oberhalb der ursprünglichen Substratoberfläche eine Aufbauzone 11 ausgebildet, die eine Vielzahl von Poren 12 umfasst, deren Anteil an der Aufbauzone 11 im Bereich von 0,2 bis 40 Vol.% liegt.

Die Aufbauzone 11 ist im Wesentlichen aus α-Chrom gebildet mit einem Anteil von 30 bis 90 Gew.%, vorzugsweise 40 bis 80 Gew.%, angereichert ist. Die α-Chrom umfasst dabei ungefähr 10 bis 80 % der gesamten sich auszubildenden Schicht.

Durch den hohen Porenanteil in der Aufbauzone weist die Aufbauzone eine Härte ≤ 800 HV (Vickershärte) auf und die Bruchdehnung ist ≥ 0,5 %. Damit ist eine Chromschicht gegeben, die sich neben einem hohen Chromanteil auch durch ihre Duktilität auszeichnet.

## Patentansprüche

1. Verfahren zur Herstellung einer Beschichtung (10,11) aus einem Metall oder einer Metalllegierung auf einem Substrat (1) über einen Diffusionsprozess, bei dem das Substrat für eine Zeitdauer von 0,5 bis 24 h in einer Atmosphäre (4) einer Temperaturbehandlung bei 800°C bis 1200°C ausgesetzt wird, wobei die Atmosphäre mindestens ein Metallhalogenid des abzuscheidenden Metalls oder der Metalllegierung umfasst, wobei als Metalle Cr, Al, Hf, Zr und/oder Y eingesetzt werden,
**dadurch gekennzeichnet, dass**
zusätzlich das Substrat zumindest teilweise mit einer Lage versehen wird, welche mindestens eine Metallhalogenid in fester und / oder flüssiger Form umfasst
wobei
- das Substrat (1) mit einem Film (2) versehen wird, der ein Metallhalogenid in flüssiger Form umfasst und
- über dem Film (2) mit flüssigem Metallhalogenid oder direkt auf dem Substrat (1) eine Pulverschicht (3) mit dem festem Metallhalogenid angeordnet wird und
- sich eine Aufbauzone (11) der Diffusionsschicht (10), die sich oberhalb der ursprünglichen Oberfläche des Substrates abscheidet, ausbildet.

2. Verfahren nach Anspruch 1,
**dadurch gekennzeichnet, dass**
das Metallhalogenid in flüssiger Form ein Metallhalogenid mit demselben Metall oder denselben Komponenten wie das Metallhalogenid der umgebenden Atmosphäre ist.

3. Verfahren nach Anspruch 1 oder 2,
**dadurch gekennzeichnet, dass**
das Metallhalogenid in der Pulverschicht dasselbe Metall wie das Metallhalogenid der umgebenden Atmosphäre aufweist.

4. Verfahren nach einem der vorhergehenden Ansprüche,
**dadurch gekennzeichnet, dass**
die Pulverschicht (3) mit festem Metallhalogenid Metallpartikel oder Inertpartikel umfasst.

5. Verfahren nach einem der vorhergehenden Ansprüche,
**dadurch gekennzeichnet, dass**
die pulverförmigen Metallhalogenidpartikel (5) eine durchschnittliche oder maximale Korngröße im Bereich von 2 µm bis 100 µm, insbesondere im Bereich von 5 µm bis 50 µm aufweisen und/oder die Metallpartikel (6) oder Inertpartikel (7) eine durchschnittliche oder maximale Korngröße im Bereich von 5 µm bis 4 mm aufweisen.

6. Verfahren nach einem der vorhergehenden Ansprüche,
**dadurch gekennzeichnet, dass**
die Metallhalogenidpartikel (5) mit einem Anteil von 0,2 Gew.% bis 50 Gew.%, insbesondere 2 Gew.% bis 10 Gew.% in der Pulverschicht 3 vorgesehen sind oder die Metallhalogenidpartikel (5) und die Metallpartikel (6) im Verhältnis von 1:1 vorgesehen sind.

7. Verfahren nach einem der vorhergehenden Ansprüche,
**dadurch gekennzeichnet, dass**
die Komponenten der aufgebrachten Lage (2,3) unter den Bedingungen der Temperaturbehandlung bei Nicht-Berücksichtigung von Reaktionen ihre Aggregatszustande beibehalten.

8. Verfahren nach einem der vorhergehenden Ansprüche,
**dadurch gekennzeichnet, dass**
die Atmosphäre (4) ein Inertgas umfasst, welches insbesondere einen Partialdruck von 20 mbar bis 1200 mbar aufweist.

9. Verfahren nach einem der vorhergehenden Ansprüche,
**dadurch gekennzeichnet, dass**
das Metallhalogenid in der Atmosphäre (4) mit einem Partialdruck von 5 mbar bis 800 mbar vorliegt.

10. Verfahren nach einem der vorhergehenden Ansprüche,
**dadurch gekennzeichnet, dass**
die Temperaturbehandlung bei 900°C bis 1150°C erfolgt.

11. Verfahren nach einem der vorhergehenden Ansprüche,
**dadurch gekennzeichnet, dass**
die Lage (2,3) eine Dicke von 0,1 mm bis 20 mm aufweist.

12. Chromschicht auf einem metallischen Substrat (1) hergestellt nach einem Verfahren gemäß einem der vorhergehenden Anspruche, wobei das abgeschiedene Metall Chrom ist,
- mit einer Diffusionszone (10) in das Substrat und
- einer Aufbauzone (11) auf dem Substrat,
**dadurch gekennzeichnet, dass**
die Diffusionszone (10)
- einen Anteil des abgeschiedenen Metalls von größer oder gleich 30 Gew.% aufweist und
die Aufbauzone (11)
- einen Chrom-Anteil von größer oder gleich 30 Gew.%
- einen α-Cr Anteil von größer oder gleich 50 Gew.% des Chromgehalts und
- einen Porenanteil von 0,2 bis 40 Vol.%
aufweist.

## Claims

1. Method for producing a coating (10, 11) made of a metal or a metal alloy on a substrate (1) by means of a diffusion process, in which the substrate is subjected to a temperature treatment at 800°C to 1200°C for a period of 0.5 to 24 h in an atmosphere (4), the atmosphere comprising at least one metal halide of the metal to be deposited or of the metal alloy, Cr, Al, Hf, Zr and/or Y being used as metals, **characterized in that**, in addition, the substrate is at least partially provided with a layer which comprises at least one metal halide in solid and/or liquid form,
- the substrate (1) being provided with a film (2) which comprises a metal halide in liquid form, and
- a powder layer (3) having the solid metal halide being arranged over the film (2) having the liquid metal halide or directly on the substrate (1), and
- a build-up region (11) of the diffusion layer (10) being formed, which region is deposited above the original surface of the substrate.

2. Method according to claim 1, **characterized in that** the metal halide in liquid form is a metal halide having the same metal or the same components as the metal halide of the surrounding atmosphere.

3. Method according to either claim 1 or claim 2, **characterized in that** the metal halide in the powder layer has the same metal as the metal halide of the surrounding atmosphere.

4. Method according to any of the preceding claims, **characterized in that** the powder layer (3) having the solid metal halide comprises metal particles or inert particles.

5. Method according to any of the preceding claims, **characterized in that** the powdered metal halide particles (5) have an average or maximum particle size in the range of 2 µm to 100 µm, in particular in the range of 5 µm to 50 µm, and/or the metal particles (6) or inert particles (7) have an average or maximum particle size in the range of 5 µm to 4 mm.

6. Method according to any of the preceding claims, **characterized in that** the metal halide particles (5) are provided in the powder layer 3 in a proportion of 0.2 wt.% to 50 wt.%, in particular 2 wt.% to 10 wt.%, or the metal halide particles (5) and the metal particles (6) are provided in a ratio of 1:1.

7. Method according to any of the preceding claims, **characterized in that** the components of the applied layer (2, 3) maintain their state of aggregation under the conditions of the temperature treatment, not taking reactions into account.

8. Method according to any of the preceding claims, **characterized in that** the atmosphere (4) comprises an inert gas which in particular has a partial pressure of 20 mbar to 1200 mbar.

9. Method according to any of the preceding claims, **characterized in that** the metal halide is present in the atmosphere (4) at a partial pressure of 5 mbar to 800 mbar.

10. Method according to any of the preceding claims, **characterized in that** the temperature treatment is carried out at 900°C to 1150°C.

11. Method according to any of the preceding claims, **characterized in that** the layer (2, 3) has a thickness of 0.1 mm to 20 mm.

12. Chromium layer on a metal substrate (1), which is produced using a method according to any of the preceding claims, the deposited metal being chromium, and has
- a diffusion region (10) in the substrate, and
- a build-up region (11) on the substrate,
**characterized in that**
the diffusion region (10) has
- a proportion of deposited metal of greater than or equal to 30 wt.%, and
the build-up zone (11) has
- a proportion of chromium of greater than or equal to 30 wt.%
- a proportion of α-Cr of greater than or equal to 50 wt.% of the chromium content, and
- a proportion of pores of 0.2 to 40 vol.%.

## Revendications

1. Procédé de fabrication d'un revêtement (10, 11) d'un métal ou d'un alliage métallique sur un substrat (1) par un procédé de diffusion, dans lequel le substrat est soumis à un traitement thermique à une température de 800 à 1 200 °C pendant une durée de 0,5 à 24 h dans une atmosphère (4), sachant que l'atmosphère comprend au moins un halogénure métallique du métal ou de l'alliage métallique à déposer, Cr, Al, Hf, Zr et/ou Y étant utilisés comme métaux,
**caractérisé en ce que**
le substrat est en outre au moins partiellement pourvu d'une couche comprenant au moins un halogénure métallique sous forme solide et/ou liquide,
sachant que
- le substrat (1) est pourvu d'un film (2) comprenant un halogénure métallique sous forme liquide, et
- une couche de poudre (3) contenant l'halogénure métallique solide est placée sur le film (2) contenant l'halogénure métallique liquide ou directement sur le substrat (1), et
- une zone d'accumulation (11) de la couche de diffusion (10), qui se dépose au-dessus de la surface initiale du substrat, est formée.

2. Procédé selon la revendication 1,
**caractérisé en ce que**
l'halogénure métallique sous forme liquide est un halogénure métallique comportant le même métal ou les mêmes composants que l'halogénure métallique de l'atmosphère environnante.

3. Procédé selon la revendication 1 ou 2,
**caractérisé en ce que**
l'halogénure métallique dans la couche de poudre comporte le même métal que l'halogénure métallique de l'atmosphère environnante.

4. Procédé selon l'une des revendications précédentes,
**caractérisé en ce que**
la couche de poudre (3) comportant un halogénure métallique solide comprend des particules métalliques ou des particules inertes.

5. Procédé selon l'une des revendications précédentes,
**caractérisé en ce que**
les particules d'halogénure métallique (5) pulvérulentes présentent une granulométrie moyenne ou maximale comprise entre 2 µm et 100 µm, en particulier entre 5 µm et 50 µm, et/ou les particules métalliques (6) ou les particules inertes (7) présentent une granulométrie moyenne ou maximale comprise entre 5 µm et 4 mm.

6. Procédé selon l'une des revendications précédentes,
**caractérisé en ce que**
les particules d'halogénure métallique (5) sont fournies dans une proportion de 0,2 à 50 % en poids, en particulier de 2 à 10 % en poids, dans la couche de poudre 3 ou **en ce que** les particules d'halogénure métallique (5) et les particules métalliques (6) sont fournies dans un rapport de 1:1.

7. Procédé selon l'une des revendications précédentes,
**caractérisé en ce que**
les composants de la couche appliquée (2, 3) conservent leur état d'agrégation dans les conditions du traitement thermique, indépendamment des réactions.

8. Procédé selon l'une des revendications précédentes,
**caractérisé en ce que**
l'atmosphère (4) comprend un gaz inerte qui présente en particulier une pression partielle de 20 à 1 200 mbar.

9. Procédé selon l'une des revendications précédentes,
**caractérisé en ce que**
l'halogénure métallique est présent dans l'atmosphère (4) à une pression partielle de 5 à 800 mbar.

10. Procédé selon l'une des revendications précédentes,
**caractérisé en ce que**
le traitement thermique est effectué entre 900 et 1 150 °C.

11. Procédé selon l'une des revendications précédentes,
**caractérisé en ce que**
la couche (2, 3) a une épaisseur de 0,1 à 20 mm.

12. Couche de chrome sur un substrat métallique (1) fabriquée par un procédé selon l'une des revendications précédentes, dans laquelle le métal déposé est du chrome,
- comportant une zone de diffusion (10) dans le substrat et
- une zone d'accumulation (11) sur le substrat,
**caractérisée en ce que**
la zone de diffusion (10)
- présente une proportion de métal déposé supérieure ou égale à 30 % en poids et **en ce que**
la zone d'accumulation (11) présente
- une proportion de chrome supérieure ou égale à 30 % en poids,
- une proportion d'a-Cr supérieure ou égale à 50 % en poids de la teneur en chrome et
- une proportion de pores de 0,2 à 40 % en volume.
